# EUROPEAN PATENT APPLICATION

(11) **EP 2 434 841 A1**
(43) Date of publication of application: **28.03.2012**
(21) Application number: 10777751.8
(22) Date of filing: 18.05.2010
(51) Int. Cl.: H05B 33/26, H01B 13/00, H01L 51/50, H05B 33/10

(54) **SURFACE TREATMENT METHOD FOR ELECTRODES AND METHOD FOR PRODUCING ELECTRODES AND ORGANIC LUMINESCENCE ELEMENTS**

(30) Priority: 19.05.2009 JP 2009121069
(71) Applicant: Showa Denko K.K., Tokyo 105-8518 (JP)
(72) Inventor: SAKO, Kanjiro, Chiba-shi Chiba 267-0056 (JP); KONDO, Kunio, Chiba-shi Chiba 267-0056 (JP)
(74) Representative: Strehl Schübel-Hopf & Partner
(86) International application number: PCT/JP2010/058350
(87) International publication number: WO 2010/134518

(57) **Abstract**

[Problem] To provide a method for increasing a work function of an electrode by a simple operation and an organic EL element which has an anode of a high work function, exhibits excellent light emission properties (luminous efficiency, lifetime), has a good luminescent surface with small unevenness of luminance and few defects and has low leakage current.

[Solution to Problem] A surface treatment method for electrodes, including a contact step of bringing an electrode made from a metal oxide into contact with a solution including a silane compound represented by the following formula (1) and/or a partially hydrolyzed condensate thereof and water, and an organic EL element having a luminescent layer and a cathode laminated in this order on a surface-treated surface of an anode made from a metal oxide, said anode having been surface-treated by the method.

Si(OR)ₚ(X)_{q}(OH)_{4-p-q} (1)

wherein in the formula (1), each OR is independently an alkoxy group or an aryloxy group, each X is independently a hydrolyzable group other than the above OR, p is an integer of 1 to 4, q is an integer of 0 to 3, and p+q≤4.

## Description

### Technical Field

The present invention relates to a surface treatment method for electrodes, an electrode, an organic electroluminescent element and a process for producing the organic electroluminescent element.

### Background Art

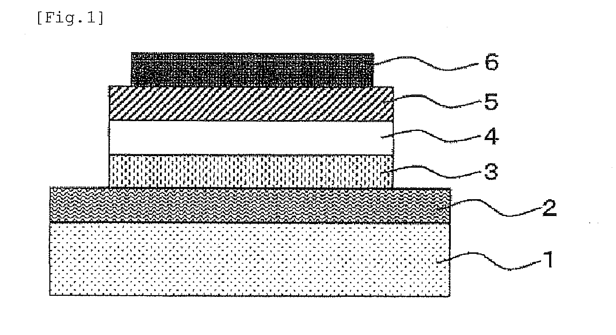

An organic electroluminescent (also referred to as "organic EL" hereinafter) element is formed by, for example, laminating an anode 2, a hole transport layer 3, a luminescent layer 4, an electron transport layer 5 and a cathode 6 in this order on a substrate 1, as shown in Fig. 1. When a positive voltage is applied to the anode 2 and a negative voltage is applied to the cathode 6, electrons injected to the luminescent layer 4 through the electron transport layer 5 and holes injected to the luminescent layer 4 through the hole transport layer 3 are recombined in the luminescent layer 4 to cause light emission.

When application of the organic EL element to a full color display or a light-emitting element for illumination and development thereof are considered, it is necessary to perform voltage lowering of the element driving voltage and to further enhance luminous efficiency. In order to realize such voltage lowering of the element driving voltage, it is necessary to enhance efficiency of injection of holes from the anode 2 and electrons from the cathode 6 to the luminescent layer 4. As a method for enhancing the efficiency of injection of holes from the anode 2, a method comprising increasing a work function of the anode 2 to minimize energy barrier against the hole transport layer 3 can be mentioned.

In the case of ITO (indium tin oxide) that is generally used as an anode, this ITO anode is thought to exhibit a work function of about -6.0 eV in principle, but when cleaning with a general organic solvent or the like that has been heretofore done is carried out, the anode only exhibits a work function of about -4.8 to -4.7 eV. The reason is thought to be that contamination with a residual carbon component due to the organic solvent or the like remains on the anode surface or that deficiency of oxygen molecules on the ITO surface occurs. On this account, a treatment, such as UV ozone cleaning or oxygen plasma treatment, is sometimes carried out after the cleaning step.

On the other hand, as a method for increasing a work function of an anode metal, a method comprising acid-treating the anode surface has been attempted in JP 1992-14795 A (patent literature 1) or JP 1997-120890 A (patent literature 2). That is to say, in the patent literature 1, the surface of the anode is subjected to acid treatment, and then the anode surface is subjected to cleaning with an organic solvent and drying, whereby the work function of the anode is made higher than that before the acid treatment by about 0.1 to 0.3 eV, that is, the work function of the anode is increased like this, whereby voltage lowering of the element driving voltage is achieved. In the patent literature 2, the anode surface is subjected to polishing treatment, then subjected to acid treatment and further subjected to cleaning with an organic solvent and drying, whereby flattening of the anode surface and formation of pores to the outermost surface are carried out to achieve voltage lowering of the element driving voltage and improvement in lifetime.

In the methods disclosed in the patent literature 1 and the patent literature 2, however, cleaning with an organic solvent or the like is carried out after the acid treatment of the anode. Therefore, a residual carbon component due to the organic solvent or the like remains on the surface of the anode, and the effect in increase of the work function is insufficient. Moreover, when the organic electroluminescent element is continuously driven, there are other problems that the luminance is decreased and the resistance of the element is increased.

In JP 2001-319777 A (patent literature 3), there is proposed an element in which an organic luminescent layer or the like is formed without performing cleaning after acid treatment of an anode, whereby a work function of the anode is increased to thereby enable voltage lowering of the element driving voltage. In the case of this element, however, lifetime properties are insufficient, and there is yet room for improvement.

In JP 2004-63210 A (patent literature 4), there is proposed a method for increasing a work function of an anode, said method comprising cleaning of the anode surface through, for example, ultraviolet ray cleaning by irradiation with a low-pressure mercury lamp, ultraviolet ray cleaning by irradiation with an excimer lamp, normal pressure plasma cleaning or vacuum plasma cleaning, and then performing surface treatment with an acid, a halogen or the like. However, there is a problem of complicated operations or the like.

In JP2007-242481A (patentliterature5), a surface treatment method for electrodes **characterized in that** an electrode made from a metal oxide is brought into contact with a nonionic surface active agent and/or a carboxylic acid-based surface active agent is disclosed. It is described that according to this method, a work function of the electrode made from a metal oxide such as indium tin oxide (also referred to as "ITO" hereinafter) can be easily increased. It is also described that by the use of this method, there can be produced an organic EL element having features that the work function of the anode is increased to enhance efficiency of injection of holes and thereby lowering of the element driving voltage becomes possible, that lifetime properties and stability of chromaticity during continuous driving can be improved, and that increase of resistance is held down to the minimum. However, there is yet room for improvement in the lifetime properties.

Inapatentliterature 6 (U.S. PatentNo. 6,127,004), it is described that when a film made of a carbon fluoride compound is formed on an anode by plasma surface treatment in the production of an organic EL element, luminous efficiency of the organic EL element is enhanced.

In a patent literature 7 (JP 1997-63771 A), it is described that when a metal oxide film is formed on an ITO anode in the production of an organic EL element, luminous efficiency of the organic EL element is enhanced. As the metal oxide, RuOₓ, MoOₓ, VOₓ and the like is mentioned, and as a method for forming the metal oxide film, electron beam deposition, direct current sputtering, RF magnetron sputtering, ICB deposition and the like is mentioned.

In the inventions described in the patent literatures 6 and 7, however, the operations are complicated since it is necessary to carry out operations for forming the film on the anode in a vacuum atmosphere.

On the other hand, in JP 1997-7770 A (patent literature 8), it is described that when an anode having a smooth surface is used, short circuits due to pinholes or the like are prevented and there can be realized an organic EL thin film element, which is improved in light emission luminance and luminous efficiency and which is extremely excellent in durability and reliability.

### Citation List

### Patent Literature

Patent literature 1: JP 1992-14795 A
Patent literature 2: JP 1997-120890 A
Patent literature 3: JP 2001-319777 A
Patent literature 4: JP 2004-63210 A
Patent literature 5: JP 2007-242481 A
Patent literature 6: U.S. Patent No. 6,127,004
Patent literature 7: JP 1997-63771 A
Patent literature 8: JP 1997-7770 A

### Summary of Invention

### Technical Problem

The present invention has been made in view of such problems as described above, and it is an object of the present invention to provide a method for increasing a work function of an electrode by a simple operation.

It is another object of the present invention to provide a process for producing an organic EL element having an anode of a high work function by a simple operation.

It is a further object of the present invention to provide an organic EL element having been improved in light emission properties (luminous efficiency, lifetime) and a process for producing the organic EL element.

It is a still further object of the present invention to enable to form a luminescent layer having uniformity and high smoothness particularly when the luminescent layer is formed by a coatingmethod, and consequently, to provide an organic EL element, which has a good luminescent surface with small unevenness of luminance and few defects and has low leakage current, and a process for producing the same.

### Solution to Problem

The present invention relates to, for example, the following [1] to [16].

### [1]

A surface treatment method for electrodes, comprising a contact step of bringing an electrode made from a metal oxide into contact with a solution comprising a silane compound represented by the following formula (1) and/or a partially hydrolyzed condensate there of and water,

Si(OR)ₚ(X)_{q}(OH)_{4-p-q} (1)

wherein each OR is independently an alkoxy group or an aryloxy group,
each X is independently a hydrolyzable group other than the above OR,
p is an integer of 1 to 4, q is an integer of 0 to 3, and p+q≤4.

### [2]

The surface treatment method for electrodes as stated in [1] wherein the silane compound is a tetraalkoxysilane.

### [3]

The surface treatment method for electrodes as stated in [2], wherein the tetraalkoxysilane is at least one compound selected from the group consisting of tetramethoxysilane, tetraethoxysilane, tetrapropoxysilane and tetrabutoxysilane.

### [4]

The surface treatment method for electrodes as stated in any one of [1] to [3], wherein the solution contains the silane compound and/or the partially hydrolyzed condensate thereof in an amount of 0.001 to 10% by mass in terms of a Si atom.

### [5]

The surface treatment method for electrodes as stated in any one of [1] to [4], wherein the solution comprises 10 to 80% by mass of water and 90 to 20% by mass of an alcohol of 1 to 3 carbon atoms, with the proviso that the total amount of them is 100% by mass.

### [6]

The surface treatment method for electrodes as stated in any one of [1] to [5], wherein pH of the solution is in the range of 1.0 to 5.0.

### [7]

The surface treatment method for electrodes as stated in any one of [1] to [5], wherein pH of the solution is in the range of 9.0 to 12.

### [8]

The surface treatment method for electrodes as stated in any one of [1] to [7], wherein the contact step is carried out by application of the solution on a surface of the electrode (also referred to as "the first contact method" hereinafter).

### [9]

The surface treatment method for electrodes as stated in [8], wherein the method of the application is a method comprising forming a liquid pool of the solution on the electrode surface and rotating the electrode in the in-plane direction of the surface to spread out the liquid pool so as to cover the whole of the electrode surface.

### [10]

The surface treatment method for electrodes as stated in any one of [1] to [7], wherein the contact step is carried out by immersing the electrode in the solution (also referred to as "the second contact method" hereinafter) or spraying the solution to the electrode (also referred to as "the third contact method" hereinafter).

### [11]

The surface treatment method for electrodes as stated in [10], which further comprises a cleaning step of cleaning the electrode with water immediately after the contact step.

### [12]

The surface treatment method for electrodes as stated in any one of [1] to [11], which further comprises a heating step of heating the electrode to 60 to 250°C in any stage after the contact step (or in any stage after the cleaning step if the cleaning step is included)

### [13]

The surface treatment method for electrodes as stated in any one of [1] to [12], which further comprises an UV irradiation step of irradiating the electrode with ultraviolet rays in any stage after the contact step (or in any stage after the cleaning step if the cleaning step is included).

### [14]

An electrode made from a metal oxide, which has been surface-treated by the method as claimed in any one of [1] to [13].

### [15]

An electrode made from indium tin oxide, which has been surface-treated by the method as stated in any one of [1] to [13] and has a work function, as measured by ultraviolet photoelectron spectroscopic analysis in the atmosphere, of -4.9 to -6.0 eV.

### [16]

An organic electroluminescent element having a luminescent layer and a cathode laminated in this order on a surface-treated surface of an anode made from a metal oxide, said anode having been surface-treated by the method as stated in any one of [1] to [13].

### Advantageous Effects of Invention

According to the surface treatment method for electrodes of the present invention, a work function of an electrode made from a metal oxide such as indium tin oxide (also referred to as "ITO" hereinafter) can be easily increased.

According to the present invention, an organic EL element having an electrode (anode) made from a metal oxide of a high work function can be easily produced.

According to the present invention, light emission properties (luminous efficiency, lifetime) of an organic EL element can be enhanced.

According to the present invention, wettability of a surface-treated anode by a luminescent layer-forming solution is improved, so that particularly when a luminescent layer is formed by a coating method, a luminescent layer having uniformity and high smoothness can be formed, and as a result, an organic E1 element having a good luminescent surface with small unevenness of luminance and few defects and having low leakage current and a process for producing the organic EL element are provided.

### Brief Description of Drawing

Fig. 1 is a sectional view of an embodiment of an organic EL element produced by the process of the present invention.

### Description of Embodiments

The surface treatment method for electrodes, the electrode, the organic electroluminescent element and the process for producing the organic electroluminescent element of the present invention are described in detail hereinafter.

### Surface treatment method for electrodes and electrode Contact step

The surface treatment method for electrodes of the present invention is characterized by comprising a contact step (also referred to as a "contact treatment step" hereinafter) of bringing an electrode made from a metal oxide into contact with a solution (also referred to as an "electrode treating solution" hereinafter) containing a specific silane compound (1) and/or a partially hydrolyzed condensate thereof and water.

When the electrode is used as an anode of an organic EL element, this contact step is usually carried out by bringing a substrate having an electrode made from a metal oxide (also referred to as a "substrate with electrode" hereinafter) into contact with the electrode treating solution.

Examples of the metal oxides that are materials of the electrode include indium tin oxide (ITO) and indium zinc oxide (IZO).

The silane compound (1) for use in the present invention is represented by the following formula (1).

Si(OR)ₚ(X)_{q}(OH)_{4-p-q} (1)

In the formula (1), each OR is independently an alkoxy group or an aryloxy group,
each X is independently a hydrolyzable group other than the above OR,
p is an integer of 1 to 4, q is an integer of 0 to 3, and p+q≤4.
The alkoxy group is, for example, an alkoxy group of 1 to 15 carbon atoms, and examples thereof include methoxy group, ethoxy group, propoxy group, butoxy group, pentyloxy group, hexyloxy group, octyloxy group and decyloxy group. Of these, methoxy group, ethoxy group, propoxy group and butoxy group are preferable.

The aryloxy group is, for example, an aryloxy group of 6 to 15 carbon atoms, and examples thereof include phenoxy group and benzyloxy group.

Examples of the other hydrolyzable groups X include halogeno groups, such as chlorine and bromine, ester groups (-O-COR wherein R is an alkyl group of 1 to 15 carbon atoms (e.g., methyl group, ethyl group, propyl group, butyl group, hexyl group, octyl group, dodecyl group) or an aryl group of 6 to 15 carbon atoms (e.g., phenyl group, naphthyl group)), and amino group.

Examples of the alkoxysilanes include:
tetraalkoxysilanes, such as tetramethoxysilane, tetraethoxysilane, tetrapropoxysilane, tetrabutoxysilane, tetrahexyloxysilane, tetraoctyloxysilane and tetradecyloxysilane;
aryloxysilanes, such as tetraphenoxysilane and tetrabenzyloxysilane;
methoxytriethoxysilane, methoxytributoxysilane, methoxytrioctyloxysilane, ethoxytripropoxysilane, ethoxytrimethoxysilane, butoxytrimethoxysilane, butoxytriethoxysilane, phenoxytriethoxysilane;
diethoxydimethoxysilane, diethoxydibutoxysilane;
chlorotrimethoxysilane, chlorotriethoxysilane, dichlorodiethoxysilane, trichloroethoxysilane;
diacetoxydimethoxysilane, chloromethoxytriethoxysilane, 6-chlorohexyloxytrimethoxysilane, 6,6,6-trifluorohexyloxytrimethoxysilane, 4-chlorobenzyloxytrimethoxysilane, γ-methacryloxypropyltriethoxysilane and N-β(aminoethyl)di-γ-aminodimethoxysilane.

Of these, tetraalkoxysilanes are preferable. When tetraalkoxysilanes are used, the progress of their hydrolysis reaction is relatively slow as compared with the case of using other compounds such as a compound containing the hydrolyzable group among the aforesaid groups, such as halogeno groups. Moreover, gelation hardly occurs. Therefore, control of the hydrolysis reaction is easily made, and reproducibility of surface treatment of electrode by the surface treatment of the present invention is high.

From the viewpoints of ease of obtaining, ease of handling and ease of handling of by-products, tetramethoxysilane, tetraethoxysilane, tetrapropoxysilane and tetrabutoxysilane are preferable, and tetraethoxysilane is particularly preferable, among the tetraalkoxysilanes.

These compounds may be used singly or may be used in combination.

The electrode treating solution comprises water.

Further, the electrode treating solution preferably contains an organic solvent in addition to water. In this case, the proportion of water is not less than 0.1% by mass, preferably 10 to 80% by mass, more preferably 15 to 60% by mass, still more preferably 20 to 40% by mass, based on 100% by mass of the total amount of water and the solvent. This proportion is a proportion at the time of initiation of the hydrolysis of the silane compound (1) in the electrode treating solution.

When the organic solvent is present in addition to water, solubility of the silane compound (1) and/or its partially hydrolyzed condensate is increased to make the electrode treating solution more homogeneous, and the surface treatment of the electrode using this solution can be carried out more uniformly.

The solvent is preferably a compound that is compatible with water and has a hydroxyl group, or a compound that is compatible with water and has an ether linkage.

Examples of the compounds having a hydroxyl group include alcohols, such as ethanol, isopropyl alcohol, n-butanol, isobutanol and tert-butanol, and cellosolves, such as methyl cellosolve, ethyl cellosolve and butyl cellosolve.
Examples of the compounds having an ether linkage include cyclic ethers, such as tetrahydrofuran and dioxane. Of these, alcohols and cyclic ethers are more preferable.

These compounds may be used singly or may be used in combination of two or more kinds.

The electrode treating solution preferably comprises water and an alcohol of 1 to 3 carbon atoms, and in this case, the proportion of water is not less than 0.1% by mass, preferably 10 to 80% by mass, more preferably 15 to 60% by mass, stillmore preferably 20 to 40% by mass, based on 100% by mass of the total amount of water and the alcohol. This proportion is a proportion at the time of initiation of the hydrolysis of the silane compound (1) in the electrode treating solution.

It is thought that when the metal oxide electrode and the electrode treating solution are brought into contact with each other, a film made from a hydrolyzed condensate of the silane compound (1) is formed on the surface of the metal oxide electrode.

Silane compounds that generate the hydrolyzed condensate are not limited to the silane compound (1), but in the surface treatment method of the present invention, surface treatment can be carried out uniformly with good reproducibility by using the silane compound (1). The reason is thought to be that because the hydrolysis rate of the silane compound (1) is not excessively high, control of the hydrolysis reaction is easily made and that because the by-product formed by the hydrolysis reaction is an alcohol or the like and has high compatibility with water, the solution exhibits high homogeneity even if the hydrolysis reaction proceeds.

The silane compound (1) and its polycondensed compound formed with the hydrolysis generally have low solubility in water and have higher solubility in alcohols such as ethanol or in polar organic solvents such as THF. On this account, when a polar solvent is used as a solvent in combination with water, uniform reaction can be accelerated without occurrence of precipitation during the hydrolysis reaction.

From the viewpoint that control of the hydrolysis reaction is more easily made and reproducibility of surface treatment is more enhanced because the progress of the hydrolysis reaction becomes slow, the electrode treating solution is preferably acidic (e.g., pH = 1.0 to 5.0, preferably 1.5 to 5.0), and for example, when the material of the electrode is ITO, pH of the solution is preferably 1.5 to 5.0.

On the other hand, from the viewpoint that the durability is enhanced, the electrode treating solution is preferably basic (e.g., pH = 9.0 to 12, preferably 9.0 to 11), and for example, when the material of the electrode is ITO, pH of the solution is preferably 9.0 to 11.

The above pH is pH at the time of initiation of the hydrolysis of the silane compound (1) in the electrode treating solution.

The concentration of the alkoxysilane in the electrode treating solution is usually not more than 10% by mass, preferably 0.001 to 5% by mass, more preferably 0.005 to 3% by mass, still more preferably 0.01 to 1% by mass, in terms of a Si atom. When the concentration is high, the period of time required for the contact step can be shortened. When the concentration is low, reproducibility and control of the contact step become easy, and the contact step is stabilized. Moreover, washing off of the solution after the contact step becomes easy. On the other hand, if the concentration is higher than the upper limit of this range, reproducibility and control of the contact step sometimes become difficult, or it sometimes becomes difficult to remove the solution from the electrode surface after completion of the contact step. If the concentration is lower than the lower limit of this range, the period of time required for the contact step sometimes becomes longer, or a change in concentration of the solution during the contact treatment step occasionally has great influence on the degree of the contact treatment to thereby make the contact treatment step unstable.

If the contact step is carried out using a solution containing insolubles or a gel component, the insolubles or the gel component sometimes adhere to the surface of the electrode or the substrate with electrode. Therefore, surface treatment of the electrode is sometimes not carried out homogeneously, and when this electrode is used as an anode of an organic EL element, luminance unevenness sometimes occurs on the luminescent surface of the organic EL element. On this account, in the preparation of the solution, it is preferable that the solution is stirred to make it homogeneous and insolubles, a gel component, etc. are removed from the solution by filtration. The average pore size of a filter used for the filtration is preferably not more than 0.5 µm, more preferably not more than 0.2 µm, and the lower limit thereof is, for example, 0.05 µm.

The electrode treating solution preferably has a viscosity of such a degree that the electrode can be immersed in the electrode treating solution, or the electrode treating solution can be sprayed to the electrode, or the electrode treating solution can be applied to the electrode (in accordance with JIS Z 8803, about 0.1 to 100 mPa·s).

The electrode treating solution may further contain a surface active agent. When a surface active agent is used, surface tension of the electrode treating solution is lowered, and the electrode is apt to be wettable by the electrode treating solution, so that the aforesaid contact treatment can be carried out more uniformly.

As the surface active agent, a nonionic surface active agent and/or a carboxylic acid-based surface active agent is specifically used.

Examples of the nonionic surface active agents include polyoxyethylene alkyl phenyl ether, polyoxyethylene alkyl ether and acylglycerol. Examples of the carboxylic acid-based surface active agents include aliphatic monocarboxylate (fatty acid soap) and alkanoyl sarcosine.

These surface active agents may be used singly or may be used in combination of two or more kinds.

The contact step is preferably carried out by applying the electrode treating solution to the electrode or the substrate with electrode, which are a treatment object (the first contact method), or by immersing the electrode or the substrate with electrode, in the electrode treating solution (the second contact method) or by spraying the electrode treating solution to the electrode or the substrate with electrode, which are a treatment object (the third contact method). When the contact step is carried out by such a method, the whole surface of the electrode or the substrate with electrode is treated at the same time and uniformly. Of these methods, the first contact method is preferable because the surface of the electrode or the substrate with electrode can be treated particularly uniformly. That the surface of the electrode or the substrate with electrode has been uniformly treated can be confirmed by, for example, small unevenness of luminance of the organic EL element prepared by the use of this electrode thus treated.

### First contact method

When the contact step is carried out by the first contact method, the method to apply the electrode treating solution to the treatment object is, for example, a method comprising forming a liquid pool of the electrode treating solution on the electrode surface and rotating the electrode in the in-plane direction of the surface to spread out the liquid pool so as to cover the whole of the electrode surface (also referred to as a "rotation method" hereinafter). In the rotation method, a liquid pool is formed by, for example, dropping the solution onto the neighborhood of an axis of rotation of the electrode or the substrate with electrode, which are a treatment obj ect, said electrode or said substrate having been fixed to a rotary head, and then the electrode or the substrate with electrode is rotated at a high speed in the in-plane direction using the center of gravity of the electrode or the substrate with electrode as an axis, whereby a film of the solution is formed on the whole surface of the electrode or the substrate with electrode. By virtue of this rotation, an excess amount of the solution is removed.

When the application is carried out by the rotation method, the film of the solution is homogenously formed with a uniform thickness on the whole surface of the electrode or the substrate with electrode, and therefore, the surface of the electrode or the substrate with electrode can be treated uniformly.

The rotation method is preferable from the viewpoint that the surface of the electrode or the substrate with electrode can be treated more uniformly and in a shorter period of time as compared with the second method and the third method described later. In addition, there is an advantage that the degree of the surface treatment of the electrode can be finely controlled by controlling the speed of the rotation.

Examples of the rotation methods include spin coating and casting. For carrying out the spin coating and the casting, hitherto publicly known spin coating device and casting device are employable.

Although the rotational speed depends upon the size or the weight of the electrode or the substrate with electrode, it is usually in the range of about 10 revolutions per minute to 10000 revolutions per minute. As the rotational speed is decreased, the thickness of the film of the solution remaining on the surface of the electrode or the substrate with electrode becomes larger, and the surface treatment can be accelerated. As the rotational speed is increased, the thickness becomes smaller, and the surface treatment can be restrained.

For applying the electrode treating solution to the treatment object, there can be also mentioned printing methods, such as microgravure coating, gravure coating, bar coating, roll coating, wire bar coating, screen printing, flexography, offset printing and ink jet printing.

In the case of using the printing method, a film of the solution can be formed with a uniform thickness on the surface of the electrode or the substrate with electrode by using a hitherto publicly known printing device and by using the solution instead of an ink that is used for printing.

The period of time required for application of the solution by the printing method is usually not longer than 1 minute, preferably 0.1 second to 5 seconds.

As the method to apply the electrode treating solution to the treatment object, a dip coating method can be also mentioned.

When the dip coating method is used, a tank containing the solution is prepared, and in the first place, the electrode or the substrate with electrode is dipped in the solution with holding the electrode or the substrate with electrode so that the direction of the normal of its treatment surface may become vertical to the liquid surface of the solution. Next, the electrode or the substrate with electrode is pulled up at a given rate in the vertical direction to the liquid surface of the solution. By virtue of this, a film of the solution is homogenously formed with a uniform thickness on the whole surface of the electrode or the substrate with electrode, and hence, the surface of the electrode or the substrate with electrode can be treated uniformly. By controlling the pull-up rate, the degree of the surface treatment can be finely controlled.

In the dip coating method, a hitherto publicly known dip coating device can be used. The pull-up rate is usually in the range of 0.1 mm per second to 100 mm per second. As the rate is decreased, the thickness of the film of the solution formed on the surface of the electrode or the substrate with electrode becomes smaller. As the rate is increased, the thickness of the film becomes larger.

The period of time required for application of the solution by the dip coating method (that is, period of time from the initiation of dipping of the substrate to the completion of pulling up) is usually not longer than 5 minutes, preferably 30 seconds to 3 minutes.

As the method to apply the electrode treating solution to the treatment object, a spray coating method can be also mentioned.

When the spray coating method is used, the solution is sprayed to the surface of the electrode or the substrate with electrode by the use of, for example, a spray gun, to form a film of the solution with a uniform thickness.

The period of time required for application of the solution by the spray coating method is usually not longer than 5 minutes, preferably 1 second to 1 minute.

According to the first contact method, a film of the solution can be formed with a uniform thickness on the surface of the electrode or the substrate with electrode. By controlling the thickness of the film of the solution, the degree of surface treatment can be controlled. As the thickness of the film of the solution is increased, the surface treatment can be accelerated. As the thickness of the film of the solution is decreased, the surface treatment can be restrained. The above method is preferable from the viewpoint that the surface of the electrode or the substrate with electrode can be treated more uniformly as compared with the second method and the third method described later.

When the contact step is carried out by the first contact method (rotation method, printing method, dip coating method, spray coating method), the thickness of the film of the solution formed is preferably in the range of 0.1 to 500 µm, more preferably 0.5 to 250 µm.

When the contact step is carried out by the first contact method (rotation method, printing method, dip coating method, spray coating method), the time required for the application operation is usually relatively short, and therefore, at the time of completion of the application of the electrode treating solution to the electrode or the substrate with electrode, modification (surface treatment) of the surface of the electrode or the substrate with electrode has not proceeded sufficiently in some cases. Even in such a case, however, by exposing the electrode or the substrate with electrode having the solution remaining on the surface to the atmosphere immediately after the completion of the application operation, the surface treatment of the electrode or the substrate with electrode can be accelerated. In the case where the first contact method has been the rotation method, rotation of the electrode or the substrate with electrode may be maintained during the exposure. In the case where the later-described cleaning step is carried out, the exposure time, that is, the time from the completion of the application operation to the initiation of the cleaning step, is usually not shorter than 10 seconds, preferably not shorter than 30 seconds, more preferably not shorter than 1 minute. The upper limit is not specifically restricted, and it may be, for example, one day.

### Second contact method

When the contact step is carried out by the second contact method, reproducibility of surface treatment of electrode can be enhanced by controlling the concentration and the temperature of the solution, the time for immersion and the stirring device.

In the second contact method, the time for immersing the electrode or the substrate with electrode in the solution is usually not shorter than 5 minutes, and because the time is greatly influenced by pH of the solution, etc., it cannot be determined indiscriminately. However, as a measure, the immersion time is preferably not shorter than 15 minutes, more preferably not shorter than 30 minutes. Although the upper limit is not specifically restricted, it may be, for example, 48 hours.

When the contact step is carried out by the second contact method, it is preferable to shake the electrode or to stir the solution or to irradiate the solution with ultrasonic waves during the immersion, from the viewpoint that the electrode surface is treated much more uniformly.

In the case where the second contact method is applied, modification (surface treatment) of the surface of the electrode or the substrate with electrode has proceeded sufficiently at the time of completion of the immersion of the electrode or the substrate with electrode in the electrode treating solution.

After the contact step is carried out by the second contact method, cleaning step is preferably arranged, as described later.

### Third contact method

When the contact step is carried out by the third contact method, the electrode or the substrate with electrode can be continuously treated by fixing a member for spraying the solution and by spraying the solution with moving the electrode or the substrate with electrode against the member. Moreover, a large substrate with electrode can be easily treated.

In the third contact method, the period of time for spraying the solution to the electrode or the substrate with electrode is usually not shorter than 5 minutes, preferably 10 minutes to 1 hour.

In the case where the contact step is carried out by the third method, it is preferable to spray the solution to the whole electrode, to spray the solution using an ultrasonic nozzle, to spray the solution using a two-fluid nozzle or to spray the solution using a high-pressure nozzle, from the viewpoint that the electrode surface is treated much more uniformly.

In the case where the third contact method is applied, modification (surface treatment) of the surface of the electrode or the substrate with electrode has proceeded sufficiently at the time of completion of the spraying of the electrode treating solution to the electrode or the substrate with electrode.

After the contact step is carried out by the third contact method, cleaning step is preferably arranged, as described later.

The temperature of the solution in the contact step is preferably in the range of 10°C to 90°C, more preferably 25 to 60°C. If the temperature is higher than the upper limit of this range, the time required for the contact step sometimes becomes too short and hence reproduction of surface treatment of electrode sometimes becomes difficult, or the electrode surface is sometimes corroded (dissolved), or the amount of evaporation of the solvent is increased to make a change in concentration of the solution larger and hence it sometimes becomes difficult to surface-treat the electrode uniformly in one electrode or among plural electrodes. On the other hand, if the temperature is lower than the lower limit of the above range, the time required for the contact step sometimes becomes excessively long.

The time required for the contact step is properly determined in the above range in consideration of the concentration of the solution, the temperature in the contact step, etc.

Since the contact step can be carried out at atmospheric pressure, complicated operations such as use of a vacuum chamber are not necessary.

According to the surface treatment method of the present invention, a work function of an electrode made from a metal oxide is increased. The expression "work function is high" means that the absolute value of the work function is large.

According to the surface treatment method of the present invention, the work function (absolute value) of an electrode that is, for example, an ITO electrode can be increased to not less than -4.9 eV, preferably -5.0 to -6.0 eV, from a usual value of about -4.8 eV given before the contact, though it depends upon the surface condition of the electrode before the treatment.

The value of the work function is a value measured by ultraviolet photoelectron spectroscopy in the atmosphere.

According to the surface treatment method of the present invention, smoothness of the treatment surface of an electrode made from a metal oxide can be enhanced. When the electrode is, for example, an ITO electrode, the surface roughness (Ra) of the surface-treated ITO electrode is preferably not more than 0.6 nm, more preferably not more than 0.4 nm, though it depends upon the conditions of the surface treatment.

It is thought that when an electrode having a rough surface is used as an anode of an organic EL element, pinholes are formed in the luminescent layer because of protrusions of the anode surface to thereby bring about short circuit or leakage current in the organic EL element. However, it is thought that the electrode having been surface-treated by the method of the present invention has a smooth surface, and therefore, when this electrode is used as an anode of an organic EL element, short circuit of the organic EL element can be prevented and leakage current can be reduced.

The electrode of the present invention is an electrode made from a metal oxide and having been surface-treated by the surface treatment method for electrodes of the present invention, and when this electrode is used as an anode of an organic EL element, luminous efficiency of the organic EL element can be enhanced, emission lifetime can be prolonged, a luminescent layer having uniformity and high smoothness can be formed, and an organic EL element which has a good luminescent surface having no luminance unevenness and no defects and which is free from leakage current can be produced.

The electrode of the present invention has higher wettability by a compound solution that is used for forming an organic EL compound layer of an organic E1 element than electrodes which have not been surface-treated. Accordingly, when the electrode of the present invention is used as an anode of an organic EL element, the compound solution can be uniformly applied onto the anode, and a uniform organic EL compound layer can be formed. Particularly when the organic EL compound is a high-molecular weight compound, its effect is remarkable.

When the electrode is made from ITO, the contact angle of the ITO electrode to water can be decreased to not more than 5° by performing the surface treatment though it depends upon the conditions of the surface treatment, while the contact angle before the surface treatment is about 10 to 90°.

### Cleaning step

If the solution remaining on the electrode after the contact step is allowed to stand, surface treatment of the electrode further proceeds or the solute is precipitated on the electrode surface after evaporation of the solvent, and therefore, when the electrode is used as an anode of an organic EL element, electrical short circuit of the organic EL element or damage of the luminescent surface sometimes occurs. On this account, especially when the contact step is carried out by the second contact method or the third contact method in the surface treatment method for electrodes of the present invention, it is preferable to further arrange cleaning step for cleaning the electrode with water to remove the solution from the electrode surface after the contact step. Moreover, when the contact step is carried out by the second contact method or the third contact method, it is preferable to initiate this cleaning step immediately after the contact step (e.g., in one minute, preferably in 30 seconds.).

On the other hand, when the contact step has been carried out by the first contact method (rotation method, printing method, dip coating method, spray coating method), the cleaning step may be arranged, but because the amount of the solution remaining on the electrode or the substrate with electrode is small, the cleaning step can be generally omitted in many cases.

Examples of the cleaning methods include brush cleaning method (method of cleaning the electrode or the substrate with electrode by a rotating roll brush with pouring water onto the electrode or the substrate with electrode), a two-fluid cleaning method (method of cleaning the electrode or the substrate with electrode by jetting compressed air (pressurized to 0.2 to 1.0 MPa) and wash water (pressurized to 0.2 to 1. 0 MPa) at the same time onto the electrode or the substrate with electrode through a nozzle), ultrasonic cleaning method (method of cleaning the electrode or the substrate with electrode by jetting water having been irradiated with ultrasonic waves to the electrode or the substrate with electrode from a nozzle having an ultrasonic wave transmission zone inside), high-pressure j et cleaning method (method of cleaning the electrode or the substrate with electrode by jetting water having been pressurized to 0.2 to 10. MPa to the electrode or the substrate with electrode), and spin cleaning method (method of cleaning the electrode or the substrate with electrode by rotating the electrode or the substrate with electrode with pouring water thereto). When cleaning is carried out by these methods, the solution can be certainly removed. Examples of materials of the brushes used for the brush cleaning method include nylon, polyester resin and polyvinyl alcohol resin.

In the case where cleaning is carried out by the brush cleaning method, it is preferable to bring the electrode or the substrate with electrode into contact with water in advance (e.g., by jetting water to electrode or the like or by immersing electrode or the like in water) in order to more certainly remove the solution.

### Heating step

The surface treatment method for electrodes of the present invention preferably further comprises a heating step of heating the electrode to 60 to 250°C, preferably 80 to 200°C, after the contact step (or after the cleaning step if the cleaning step is included). When the electrode is used as an anode of an organic EL element, this heating step is carried out prior to the formation of the luminescent layer of the organic EL element. Examples of means for the heating include irradiation with infrared rays, irradiation with hot air, irradiation using a halogen lamp, and irradiation with ultraviolet rays using a UV lamp.

When this heating step is arranged, the effect of the surface treatment of the electrode is further enhanced.

For example, when the electrode is used as an anode of an organic EL element, luminous efficiency of the organic EL element is further enhanced. Its mechanism is thought to be, for example, that if water remains on a part of the electrode by the contact step or if a hydroxyl group (=Si-OH) is formed by the contact step, this water or water derived from the hydroxyl group passes through the luminescent layer (organic EL layer) with time to thereby deteriorate a cathode buffer layer formed from Ba, Ca, alkali metal or the like, and as a result, luminous efficiency is lowered, but by performing the heating step, the electrode surface is dehydrated, so that the cathode buffer layer is not deteriorated, and as a result, luminous efficiency is enhanced.

In order to prevent adsorption of water or an organic substance on the surface of the electrode or the substrate with electrode having been subjected to the heating, it is preferable to rapidly transfer the electrode or the substrate with electrode into an atmosphere which does not contain water or organic substance (e.g., nitrogen, argon, dry air) after the heat treatment, and it is more preferable to carry out the heat treatment in this atmosphere.

### UV irradiation step

The surface treatment method for electrodes of the present invention preferably further comprises an UV irradiation step of irradiating the electrode with ultraviolet rays (wavelength region: 200 to 400 nm) after the contact step (or after the cleaning step if the cleaning step is included). When the electrode is used as an anode of an organic EL element, this heating step is carried out prior to the formation of the luminescent layer of the organic EL element. In the case where the surface treatment method for electrodes of the present invention includes the heating step, the UV irradiation step may be carried out in any of stages before the heating step, after the heating step and simultaneously with the heating step.

Examples of light sources of ultraviolet rays include a high-pressure mercury lamp, a medium-pressure mercury lamp, a low-pressure mercury lamp, a xenon lamp, a metal halide lamp and a deuterium lamp.

The ultraviolet ray irradiation dose is preferably in the range of 0.01 to 10 J/cm² in the irradiation target (electrode or substrate with electrode).

The ultraviolet ray irradiation is preferably carried out uniformly over the whole surface of the electrode or the substrate with electrode, and if the whole surface cannot be irradiated with ultraviolet rays at once, the electrode or the substrate with electrode, or the light source of ultraviolet rays may be moved to perform irradiation of the whole surface.

### Organic EL element and process for producing the same

The organic EL element of the present invention has a structure in which a luminescent layer and a cathode are laminated in this order on a surface-treated surface of an electrode (anode) made from a metal oxide, said electrode having been surface-treated by the aforesaid method.

Such an organic EL element of the present invention can be produced by laminating a luminescent layer and a cathode in this order on a surface-treated surface of an electrode (anode) made from a metal oxide, said electrode having been surface-treated by the aforesaid method.

Constitution of the organic EL element of the present invention is described below.

### 1. Constitution of element

Fig. 1 is a sectional view showing an example of constitution of the organic EL element of the present invention, and between an anode provided on a transparent substrate and a cathode, a hole transport layer, a luminescent layer and an electron transport layer are provided in order.
The constitution of the organic EL element of the present invention is not limited to the example of Fig. 1, and there can be mentioned such an element constitution that (1) anode buffer layer/hole transport layer/luminescent layer, (2) anode buffer layer/luminescent layer/electron transport layer, (3) anode buffer layer/hole transport layer/luminescent layer/electron transport layer, (4) anode buffer layer/layer containing a hole-transporting compound, a luminescent compound and an electron-transporting compound, (5) anode buffer layer/layer containing a hole-transporting compound and a luminescent compound, (6) anode buffer layer/layer containing a luminescent compound and an electron-transporting compound, (7) anode buffer layer/layer containing a hole and electron-transporting compound and a luminescent compound, or (8) anode buffer layer/luminescent layer/hole block layer/electron transport layer are provided between the anode and the cathode in order. The number of the luminescent layer shown in Fig. 1 is one, but two or more luminescent layers may be provided. Further, a layer containing a hole-transporting compound may be in direct contact with the surface of the anode without using an anode buffer layer.

In the present specification, a compound which includes all of an electron-transporting compound, a hole-transporting compound and a luminescent compound or one or more of them is referred to as an "organic EL compound", and a layer which includes all of them or one or more of them is referred to as an "organic EL compound layer".

### 2. Anode

The organic EL element of the present invention has, as an anode, an electrode made from a metal oxide and having been surface-treated by the aforesaid method.

For the electrode, a substance which preferably has a surface resistivity of not more than 1000 Ω□, more preferably not more than 100 Ω□, in the temperature range of -5 to 80°C and whose electrical resistance does not markedly change by an alkaline aqueous solution can be used.

In the case where light is taken out from the anode side of the organic EL element (in the case of bottom emission), the anode needs to be transparent to visible light (average transmittance for the light of 380 to 680 nm is not less than 50%). Therefore, examples of materials of the anode include indium tin oxide (ITO) and indium zinc oxide (IZO). If ease of obtaining as a material of an anode of an organic EL element is taken into consideration, ITO is preferable between them.

In the case where light is taken out from the cathode side of the organic EL element (in the case of top emission), light transmittance of the anode is not restricted, and as a material of the anode, ITO, IZO, stainless steel, or a simple substance of copper, silver, gold, platinum, tungsten, titanium, tantalum or niobium, or an alloy of these metals is employable.

In order to realize high light transmittance, the thickness of the anode is preferably in the range of 2 to 300 nm in the case of the bottom emission, and is preferably in the range of 2 nm to 2 mm in the case of the top emission.

### 3. Anode buffer layer (case of using Baytron or the like)

When the anode buffer layer is prepared by coating through a wet process, film formation can be carried out by the use of a coating method, such as spin coating, casting, microgravure coating, gravure coating, bar coating, roll coating, wire bar coating, dip coating, spray coating, screen printing, flexography, offset printing and ink jet printing.

The compound employable for the film formation by the wet process is not specifically restricted provided that it is a compound having good adhesion to the anode surface and an organic EL compound contained in a layer present on the anode buffer layer. However, it is more preferable to apply an anode buffer which has been generally used so far. For example, conductive polymers, such as PEDOT-PSS that is a mixture of poly(3,4)-ethylenedioxythiophene and polystyrenesulfonate and PANI that is a mixture of polyaniline and polystyrenesulfonate, can be mentioned. To these conductive polymers, an organic solvent, such as toluene and isopropyl alcohol, may be added prior to use. Further, conductive polymers containing a third component such as a surface active agent may be used. As the surface active agent, for example, a surface active agent containing one kind of a group selected from the group consisting of alkyl group, alkylaryl group, fluoroalkyl group, alkylsiloxane group, sulfate, sulfonate, carboxylate, amide, betaine structure and quaternized ammonium group is employable, and a fluoride-based nonionic surface active agent is also employable.

### 4. Organic E1 compound

As the compound used for the organic E1 compound layers, namely, luminescent layer, hole transport layer and electron transport layer, in the organic EL element of the present invention, any of a low-molecular weight compound and a high-molecular weight compound can be used.

As examples of the organic EL compounds for forming the luminescent layer of the organic EL element of the present invention, luminescent low-molecular weight compounds and luminescent high-molecular weight compounds described in Yutaka Ohmori: OYO BUTURI (Applied Physics), Vol. 70, No. 12, pp. 1419-1425 (2001) can be given. From the viewpoint that the element preparation process can be simplified, the luminescent high-molecular weight compounds are preferable between them, and from the viewpoint of high luminous efficiency, phosphorescent compounds are preferable. Therefore, phosphorescent high-molecular weight compounds are particularly preferable.

The luminescent high-molecular weight compounds can be classified into conjugated luminescent high-molecular weight compounds and non-conjugated luminescent high-molecular weight compounds, and of these, the non-conjugated luminescent high-molecular weight compounds are preferable.

From the above reasons, phosphorescent non-conjugated high-molecular weight compounds (luminescent materials that are the phosphorescent high-molecular weight compounds and are the non-conjugated luminescent high-molecular weight compounds) are particularly preferable.

The luminescent layer in the organic EL element of the present invention preferably contains at least a phosphorescent high-molecular weight compound having, in one molecule, a phosphorescent unit that emits phosphorescence and a carrier transport unit that transports a carrier. The phosphorescent high-molecular weight compound is obtained by copolymerizing a phosphorescent compound having a polymerizable substituent and a carrier-transporting compound having a polymerizable substituent. The phosphorescent compound is a metal complex containing one metal element selected from iridium, platinum and gold, and above all, an iridium complex is preferable.

Examples of the phosphorescent compounds having a polymerizable substituent include compounds wherein one or more hydrogen atoms of metal complexes represented by the following formulas (E-1) to (E-49) are replaced with a polymerizable substituent(s).

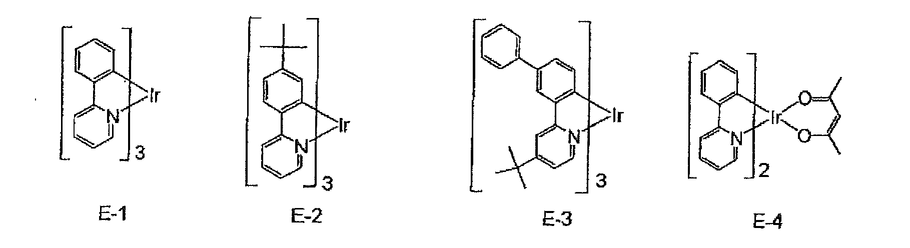

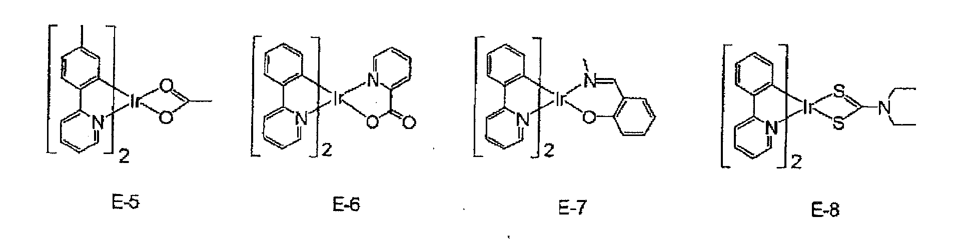

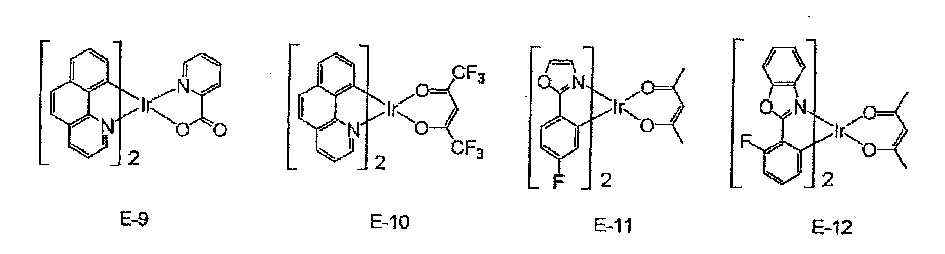

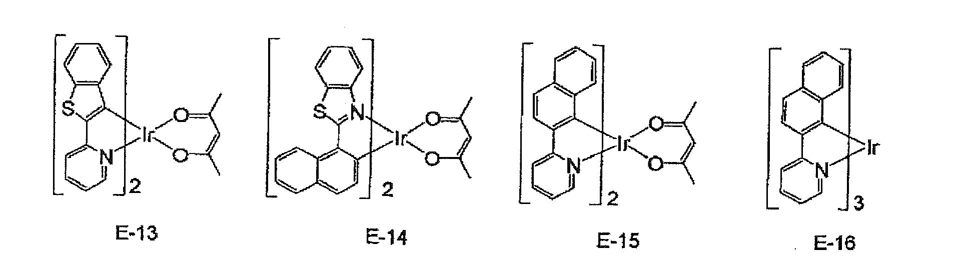

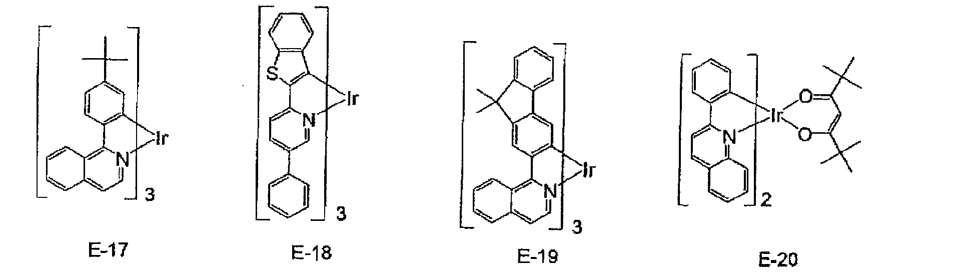

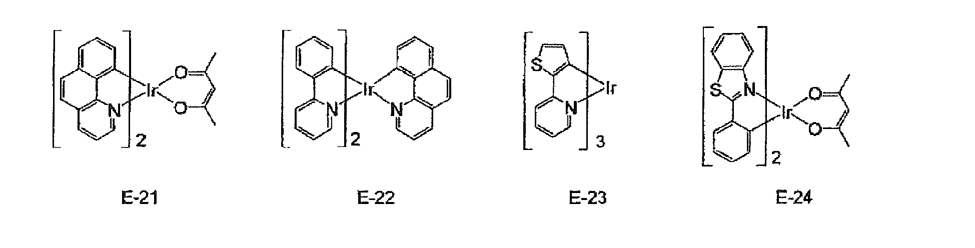

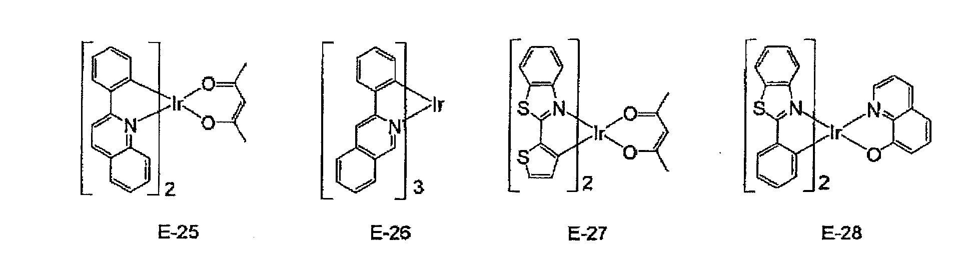

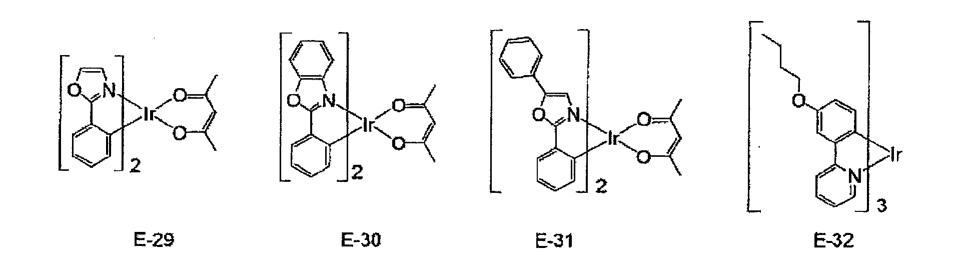

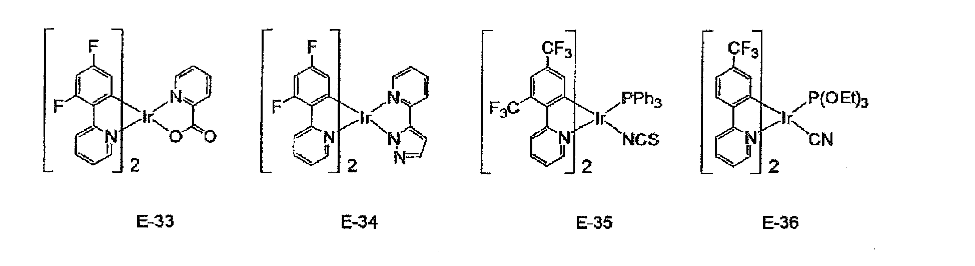

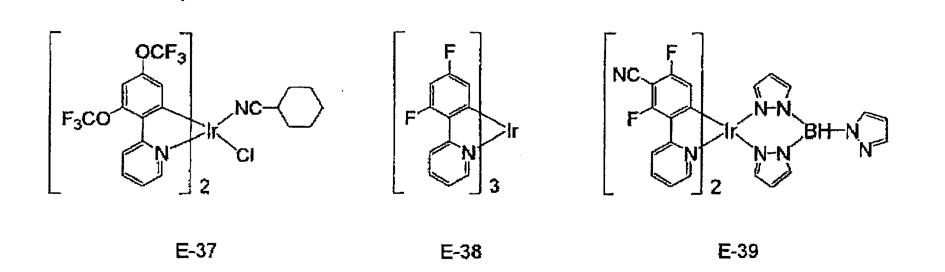

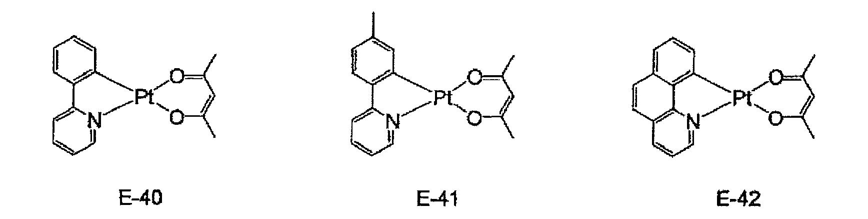

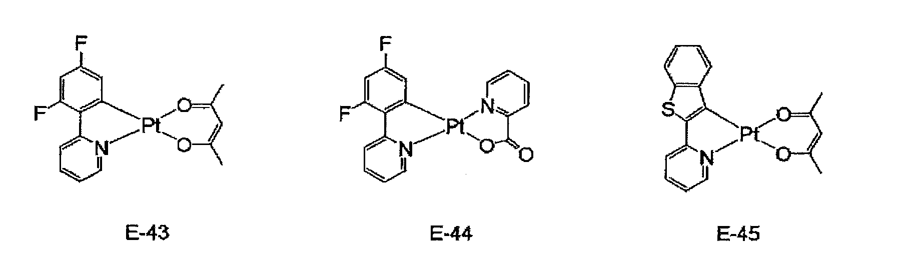

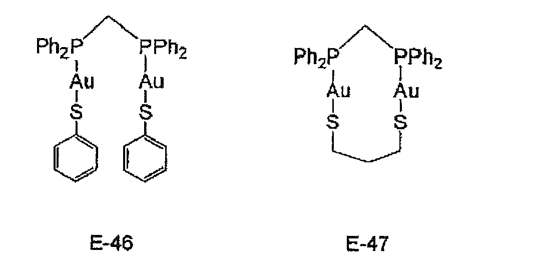

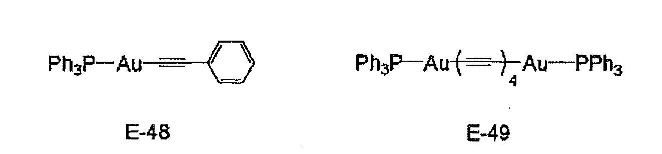

In the formulas (E-35) and (E-46) to (E-49), Ph represents a phenyl group.

Examples of the polymerizable substituents in these phosphorescent compounds include vinyl group, acrylate group, methacrylate group, urethane(meth)acrylate groups such as methacryloyloxyethylcarbamate group, styryl group and its derivatives, and vinylamide group and its derivatives. Of these, vinyl group, methacrylate group, and styryl group and its derivatives are preferable. These substituents may be bonded to a metal complex through an organic group of 1 to 20 carbon atoms which may have a hetero atom.

The carrier-transporting compound having a polymerizable substituent is, for example, a compound wherein one or more hydrogen atoms in an organic compound having one or both of hole-transporting function and electron-transporting function are replaced with a polymerizable substituent(s). As typical examples of such compounds, compounds represented by the following formulas (E-50) to (E-67) can be given.

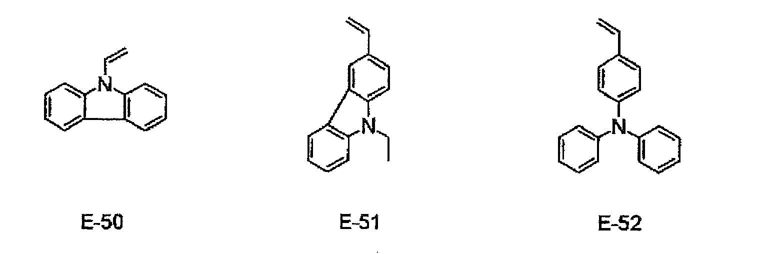

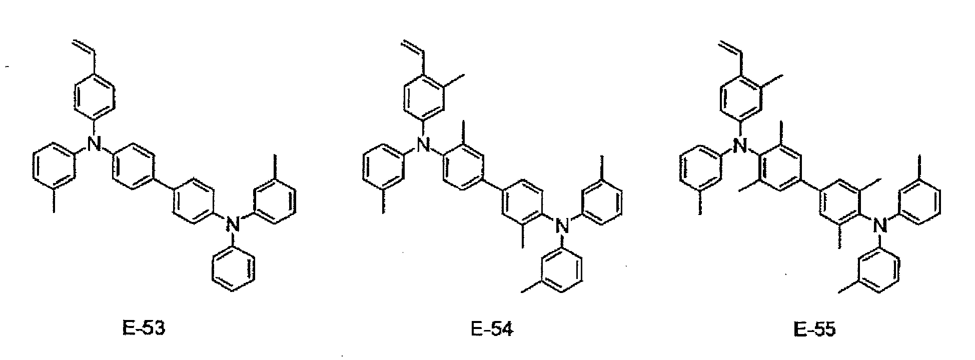

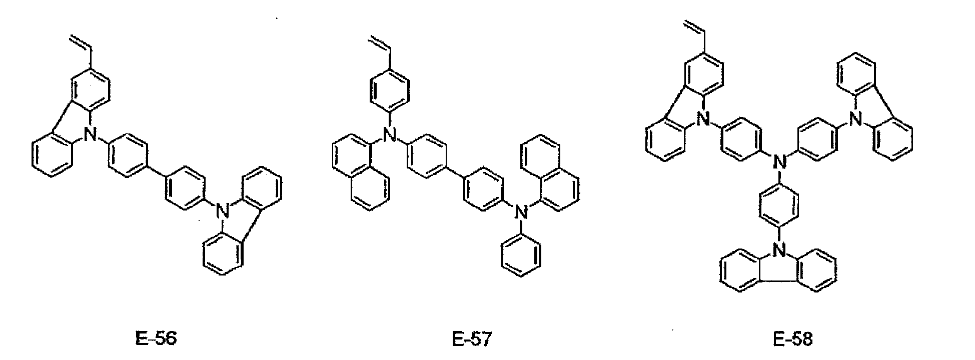

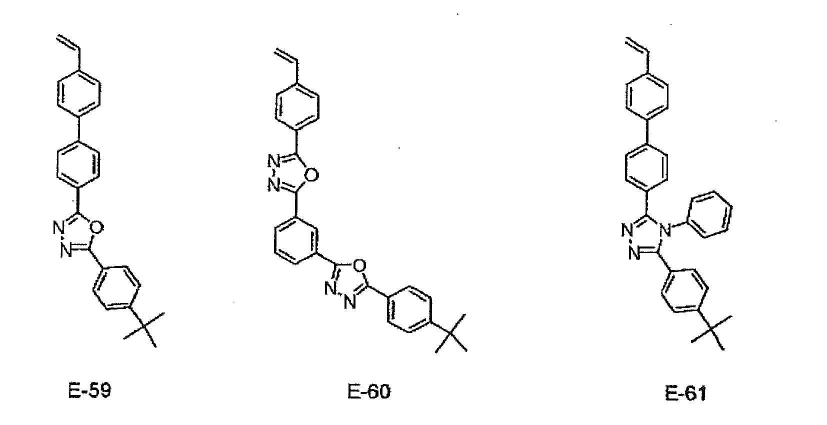

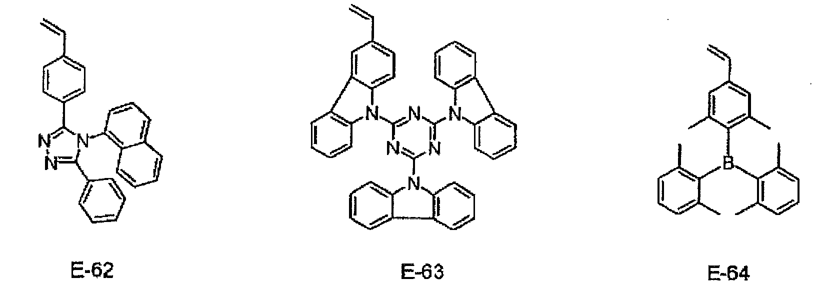

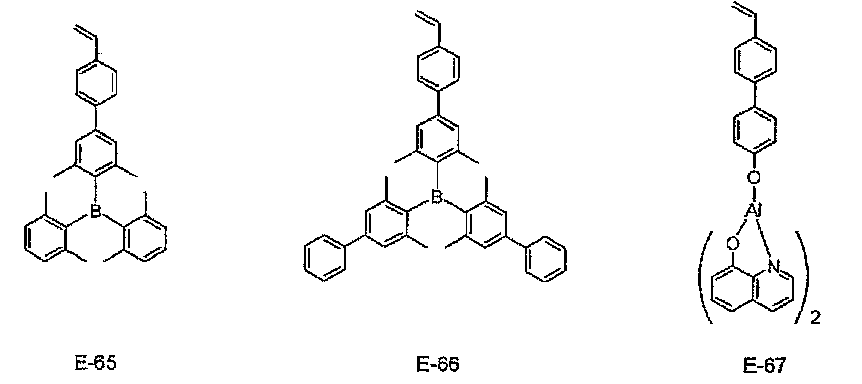

The polymerizable substituent in the carrier-transporting compounds given as examples is vinyl group, but the carrier-transporting compounds may be compounds wherein vinyl group in these compounds is replaced with a polymerizable substituent, e.g., acrylate group, methacrylate group, urethane(meth)acrylate groups such as methacryloyloxyethylcarbamate group, styryl group and its derivatives, and vinylamide group and its derivatives. These polymerizable substituents may be bonded through an organic group of 1 to 20 carbon atoms which may have a hetero atom.

The process for polymerizing the phosphorescent compound having a polymerizable substituent and the carrier-transporting compound having a polymerizable substituent may be any of radical polymerization, cationic polymerization, anionic polymerization and addition polymerization, but the radical polymerization is preferable. The molecular weight (weight-average molecular weight) of the polymer is preferably in the range of 1,000 to 2,000,000, more preferably 5,000 to 1,000,000. The molecular weight referred to herein is a molecular weight in terms of polystyrene as measured by GPC (gel permeation chromatography).

Thephosphorescenthigh-molecularweightcompound may be a compound obtained by copolymerizing one phosphorescent compound and one carrier-transporting compound, or one phosphorescent compound and two or more carrier-transporting compounds, or may be a compound obtained by copolymerizing two or more phosphorescent compounds and a carrier-transporting compound.

The monomer arrangement in the phosphorescent high-molecular weight compound may be any arrangement of a random copolymer, a block copolymer and an alternating copolymer. When the number of repeating units of the phosphorescent compound structure is represented by m and the number of repeating units of the carrier-transporting compound structure is represented by n (m and n are each an integer of 1 or greater), the ratio of the number of repeating units of the phosphorescent compound structure to the number of all the repeating units, that is, the value of m/ (m+n), is preferably in the range of 0.001 to 0.5, more preferably 0.001 to 0.2.

More specific examples of the phosphorescent high-molecular weight compounds and the synthesis methods are disclosed in, for example, Patent Literatures JP 2003-342325 A, JP 2003-119179 A, JP 2003-113246 A, JP 2003-206320 A, JP 2003-147021 A, JP 2003-171391 A, JP 2004-346312 A and JP 2005-97589 A.

The luminescent layer in the organic EL element produced by the process of the present invention is preferably a layer containing the phosphorescent compound, but for the purpose of compensating for the carrier transport property of the luminescent layer, a hole-transporting compound or an electron-transporting compound may be contained. Examples of the hole-transporting compounds used for that purpose include low-molecular weight triphenylamine derivatives, such as TPD (N,N'-dimethyl-N,N'-(3-methylphenyl)-1,1'-biphenyl-4,4'-diamine), α-NPD (4,4'-bis[N-(1-naphthyl)-N-phenylamino]biphenyl) and m-MTDATA (4,4',4"-tris(3-methylphenylphenylamino)triphenylamine); polyvinylcarbazole; high-molecular weight compounds obtained by introducing polymerizable substituents into the above triphenylamine derivatives and polymerizing them, such as high-molecular weight compounds of triphenylamine skeleton disclosed in Japanese Patent Laid-Open Publication No. 157575/1996;, polyparaphenylenevinylene; and polydialkylfluorene. As the electron-transporting compounds, there can be used known electron-transporting compounds, e.g., low-molecular weight materials, such as quinolinol derivative metal complexes, specifically Alq3 (aluminum trisquinolinolate), oxadiazole derivatives,triazole derivatives,imidazole derivatives, triazine derivatives and triarylborane derivatives; and high-molecular weight compounds obtained by introducing polymerizable functional groups into the above low-molecular weight electron-transporting compounds and then polymerizing them, such as poly PBD disclosed in JP 1998-1665 A.

### 5. Method for forming organic EL compound layer

The organic EL compound layer can be formed by a resistance heating deposition method, an electron beam deposition method, a sputtering method or a coating method, such as spin coating, casting, microgravure coating, gravure coating, bar coating, roll coating, wire bar coating, dip coating, spray coating, screen printing, flexography, offset printing and ink jet printing. In the case of the luminescent low-molecular weight compound, a resistance heating deposition method or an electron beam deposition method is mainly used, and in the case of the luminescent high-molecular weight compound, a coatingmethod, such as spin coating, casting, microgravure coating, gravure coating, bar coating, roll coating, wire bar coating, dip coating,spray coating,screen printing,flexography,offset printing or ink jet printing, is mainly used.

### 6. Hole block layer

For the purpose of inhibiting passing of holes through the luminescent layer and thereby efficiently recombining holes with electrons in the luminescent layer, a hole block layer may be provided adjacent to the cathode side surface of the luminescent layer. For this hole block layer, a compound which has a deeper highest occupied molecular orbital (HOMO) level than the luminescent compound can be used, and examples of such compounds include triazole derivatives, oxadiazole derivatives, phenanthroline derivatives and aluminum complexes.

Moreover, for the purpose of preventing deactivation of exciton by a cathode metal, an exciton block layer may be provided adjacent to the cathode side surface of the luminescent layer. For this exciton block layer, a compound having larger excited triplet state energy than the luminescent compound can be used, and examples such compounds include triazole derivatives, phenanthroline derivatives and aluminum complexes.

### 7. Cathode

As a material of the cathode of the organic EL element of the present invention, a material which has a low work function and is chemically stable is used. Examples of the materials include known cathode materials, such as Al, an MgAg alloy and alloys of Al and alkali metals, specifically, AlLi and AlCa. If chemical stability is taken into consideration, the work function is preferably not more than -2.9 eV. For forming a film of such a cathode material, a resistance heating deposition method, an electron beam deposition method, a sputtering method, an ion plating method or the like can be used. The thickness of the cathode is preferably in the range of 10 nm to 1 µm, more preferably 50 to 500 nm.

For the purpose of lowering a barrier to injection of electrons from the cathode to the organic layer and thereby enhancing electron injection efficiency, a metal layer having a lower work function than the cathode may be interposed as a cathode buffer layer between the cathode and an organic layer adjacent to the cathode. Examples of metals having a low work function employable for such purpose include alkali metals (Na, K, Rb, Cs), alkaline earth metals (Sr, Ba, Ca, Mg), and rare earth metals (Pr, Sm, Eu, Yb). Further, an alloy or a metal compound can be also used provided that it has a lower work function than the cathode. For forming such a cathode buffer layer, a deposition method, a sputtering method or the like can be used. The thickness of the cathode buffer layer is preferably in the range of 0.05 to 50 nm, more preferably 0.1 to 20 nm, still more preferably 0.5 to 10 nm.

The cathode buffer layer may be formed as a mixture of the above substance having a low work function and an electron-transporting compound. As the electron-transporting compound employable herein, the aforesaid organic compound for use in the electron transport layer can bementioned. As the film formation method in this case, a co-deposition method is employable. When the film formation by application of a solution is possible, the aforesaid film formation methods, such as spin coating, dip coating, ink jet method, printing, spraying and dispenser method, are employable. The thickness of the cathode buffer layer in this case is preferably in the range of 0.1 to 100 nm, more preferably 0.5 to 50 nm, still more preferably 1 to 20 nm. Between the cathode and the organic substance layer, a layer formed from a conductive high-molecular weight compound or a layer formed from a metal oxide, a metal fluoride, an organic insulating material or the like and having an average film thickness of not more than 2 nm may be provided.

### 8. Sealing

After the preparation of the cathode, a protective layer to protect the organic EL element may be provided. In order to stably use the organic EL element for a long period of time, it is preferable to provide a protective layer and/or a protective cover to protect the element from external environment. For the protective layer, a high-molecular weight compound, a metal oxide, a metal fluoride, a metal boride, etc. can be used. As the protective cover, a glass plate, a plastic plate whose surface has been subjected to treatment for lowering water permeability, a metal or the like can be used. It is preferable to attach the cover onto the substrate of the element with a thermosetting resin or a photo-curing resin to carry out sealing. If a spacer is used to hold a space, the element is easily prevented from being damaged. If the space is filled with an inert gas such as nitrogen or argon, oxidation of the cathode can be prevented. Besides, by placing a desiccant such as barium oxide in the space, it becomes easy to restrain water adsorbed on the element during the production process from doing damage to the element. It is preferable to take one or more measures among them.

### 9. Type of substrate

For the substrate of the organic EL element of the present invention, a material which satisfies mechanical strength required for organic EL elements and which is not substantially dissolved or deformed when it is immersed in the aforesaid alkaline aqueous solution is used.

For the organic EL element of bottom emission type, a substrate which is transparent to visible light is used, and specifically, a substrate made of glass, such as soda glass and alkali-free glass, transparent plastic, such as acrylic resin, methacrylic resin, polycarbonate resin, polyester resin and nylon resin, silicone, or the like can be used.

For the organic EL element of top emission type, a substrate made of a simple substance of copper, silver, gold, platinum, tungsten, titanium, tantalum or niobium, an alloy of these metals, stainless steel or the like can be used in addition to the substrate employable for the organic EL element of bottom emission type.

The thickness of the substrate is preferably in the range of 0.1 to 10 mm, more preferably 0.25 to 2 mm, though it depends upon the mechanical strength required.

### Examples

The present invention is further described with reference to the following examples, but it should be construed that the present invention is in no way limited to those examples.

### Glass substrate with ITO film

As a glass substrate with ITO film to be subjected to surface treatment, Flat ITO (shape: 200 mm square, work function of ITO electrode: -4.8 eV, contact angle to water: 25°) manufactured by Geomatec Co., Ltd. was used.

### Measuring method

### 1. ITO Electrode (ITO film)

### Work function

Work function was measured by atmospheric photoelectron spectroscopy (AC-2, manufactured by Riken Keiki Co., Ltd.).

### Surface roughness

Surface roughness Ra was measured (observation visual field: 1 µm, in accordance with JIS1994 method) by the use of an atomic force microscope (manufactured by Keyence Corporation, atomic force microscope of VN-8010 model).

### Contact angle

A water droplet having a diameter of 100 µm was allowed to fall on a surface of a glass substrate with ITO film, and using CA-D (manufactured by Kyowa Interface Science Co., Ltd.), the contact angle was measured by a liquid-drop method (θ/2 method). In Table 1, a contact angle of less than 4° means a case where the water drop having been allowed to fall does not become circular and the contact angle cannot be numerically determined.

### 2. Organic EL element

### Luminous efficiency

Using a constant voltage power source (manufactured by Keithley Instruments Inc., SM2400), a voltage was applied stepwise to the organic EL element, and luminous intensity of this organic EL element was determined by a luminance meter (manufactured by Topcon Corporation, BM-9). Further, from a ratio of the luminous intensity to the current density, luminous efficiency was determined.

### Emission lifetime

To the organic EL element, a constant current was continuously applied by the use of the same device, and luminance was measured at regular intervals, whereby emission lifetime (a period of time at the end of which the initial luminance is reduced by half) was measured.

### Luminance unevenness

Luminance was measured at arbitrary 10 points in an arbitrary region of 4 cm square on the luminescent surface, and luminance unevenness was evaluated by the degree of dispersion of the luminance. Specifically, the standard deviation of the luminance at the 10 points was divided by the average value of the luminance at the 10 points to determine a value (relative standard deviation). As this value is decreased, the luminance unevenness is judged to be smaller.

### Leakage current

A reverse voltage of 5V was applied to the organic EL element to measure a current value based on the unit element area. As this value is decreased, the leakage current is judged to be smaller.

### Preparation Example 1

In dehydrated toluene, a compound represented by the aforesaid formula E-2 (iridium complex having polymerizable substituent), a compound represented by the aforesaid formula E-54 (hole-transporting compound) and a compound represented by the aforesaid formula E-66 (electron-transporting compound) were dissolved in a ratio of 1:4:5 (E-2:E-54:E-66, by mass), and as a polymerization initiator, V-601 (available from Wako Pure Chemical Industries, Ltd.) was further dissolved. After they were subjected to freeze-degassing operation, vacuum sealing was conducted, and the solution was stirred at 70°C for 100 hours to perform reaction. After the reaction, the reaction solution was added dropwise to acetone to cause precipitation. Further, reprecipitation purification with toluene-acetone was repeated 3 times to purify the phosphorescent high-molecular weight compound. As acetone and toluene, those obtained by distillation of acetone and toluene of high purity grade (available from Wako Pure Chemical Industries, Ltd.) were used.

The solvent after the reprecipitation purification operation was analyzed by high performance liquid chromatography. It was confirmed that a substance having an absorption at not less than 400 nm was not detected in the solvent after the reprecipitation purification of the third time.

The thus purified phosphorescent high-molecular weight compound was vacuum dried over a period of 2 days at room temperature.

It was confirmed by high performance liquid chromatography (detection wavelength: 254 nm) that the purity of the resulting phosphorescent high-molecular weight compound (ELP) exceeded 99.9%.

### Example 1

125 ml (125 g) of pure water (electric conductivity: 1 µS/cm) and 375 ml (296 g) of ethanol were mixed and stirred to obtain a mixed solvent (proportion of water: 30% by mass). To this mixed solvent, 0.005 mol of tetraethoxysilane (available from Kanto Chemical Co., Ltd.) was added dropwise to prepare a surface treating solution 1 having a concentration of 0.03% by weight in terms of a Si atom and having pH of 7.0, followed by allowing the solution to stand for 1 hour. In this surface treating solution 1, a glass substrate with ITO film was immersed at room temperature (25°C), and the solution was stirred by a magnetic stirrer for 2 hours. The solution after the stirring was transparent, and any precipitate was not observed in the solution.

Next, the substrate with ITO film was taken out, transferred immediately into a beaker filled with pure water and slightly shaken for 5 minutes to clean the glass substrate with ITO film. This substrate was taken out, set immediately on a spin-drying device and rotated at 3000 rpm to dry the surface of the substrate with ITO film.

The surface of the glass substrate with ITO film was allowed to stand for 1 hour at room temperature to further dry the surface, and thereafter, work function of the ITO film surface and surface roughness of the ITO film were measured. The results are set forth in Table 1.

After the measurement, the ITO film side surface of the substrate was coated with a luminescent solution (3 mass% toluene solution of the phosphorescent high-molecular weight compound (ELP) obtained in Preparation Example 1) by spin coating (rotational speed: 3000 rpm) in the atomosphere, and then the substrate was allowed to stand for 1 hour at 120°C in a nitrogen atmosphere. Thereafter, the substrate was placed in a vacuum deposition chamber, then on the luminescent layer of the substrate was formed a LiF film having a thickness of 0.5 nm as a cathode buffer layer by a vacuum deposition device, and subsequently, an Al film having a thickness of 150 nm was formed as a cathode to produce an organic EL element.

Luminous efficiency, emission lifetime, luminance unevenness and leakage current of the resulting organic EL element are set forth in Table 3.

### Example 2

In 500 ml of pure water (electric conductivity: 1 µS/cm), 0.012 mol of sodium hydrogencarbonate (NaHCO₃ was dissolved, and they were stirred to obtain a solution. To this solution, 0.005 mol of tetraethoxysilane (available from Kanto Chemical Co., Ltd.) was added dropwise to prepare a surface treating solution 2 having a concentration of 0.03% by weight in terms of a Si atom and having pH of 10, followed by allowing the solution to stand for 1 hour. In this surface treating solution 2, a glass substrate with ITO film was immersed at room temperature (25°C), and the solution was stirred by a magnetic stirrer for 0.5 hour. In the solution after the stirring, a precipitate was observed.

The subsequent treatment of the glass substrate with ITO film and production of an organic EL element were carried out in the same manner as in Example 1.

The measurement results of the ITO film and the organic EL element are set forth in Table 3.

### Example 3

125 ml of pure water (electric conductivity: 1 µS/cm) and 375 ml of ethanol were mixed and stirred to obtain a mixed solvent. In this mixed solvent, 0.012 mol of sodium hydrogencarbonate (NaHCO₃) was dissolved, and they were stirred to obtain a solution. To this solution, 0.005 mol of tetraethoxysilane (available from Kanto Chemical Co., Ltd.) was added dropwise to prepare a surface treating solution 3 having a concentration of 0.03% by weight in terms of a Si atom and having pH of 10, followed by allowing the solution to stand for 1 hour. Inthissurfacetreatingsolution3, aglasssubstrate with ITO filmwas immersed at room temperature (25°C), and the solution was stirred by a magnetic stirrer for 0.5 hour. The solution after the stirring was transparent, and any precipitate was not observed in the solution.

The subsequent treatment of the glass substrate with ITO film and production of an organic EL element were carried out in the same manner as in Example 1.

The measurement results of the ITO film and the organic EL element are set forth in Table 3.

### Example 4

1.15 ml of hydrochloric acid (hydrogen chloride (HCl) concentration: 12 mol/l, available from Kanto Chemical Co., Ltd.), 125 ml of pure water (electric conductivity: 1 µS/cm) and 375 ml of ethanol were mixed and stirred to obtain a solution. To this solution, 0.005 mol of tetraethoxysilane (available from Kanto Chemical Co., Ltd.) was added dropwise to prepare a surface treating solution 4 having a concentration of 0.03% by weight in terms of a Si atom and having pH of 1.8, followed by allowing the solution to stand for 1 hour. In this surface treating solution 4, a glass substrate with ITO film was immersed at room temperature (25°C), and the solution was stirred by a magnetic stirrer for 2 hours. The solution after the stirring was transparent, and any precipitate was not observed in the solution.

The subsequent treatment of the glass substrate with ITO film and production of an organic EL element were carried out in the same manner as in Example 1.

The measurement results of the ITO film and the organic EL element are set forth in Table 3.

### Example 5

0.5 ml of acetic acid, 125 ml (125 g) of pure water (electric conductivity: 1 µS/cm) and 400 ml (314 g) of isopropanol were mixed and stirred to obtain a solution (proportion of water: 28% by mass). To this solution, 0. 005 mol of tetraethoxysilane (available from Kanto Chemical Co., Ltd.) was added dropwise to prepare a surface treating solution 5 having a concentration of 0.03% by weight in terms of a Si atom and having pH of 5.0, followed by allowing the solution to stand for 1 hour. In this surface treating solution 5, a glass substrate with ITO film was immersed at room temperature (25°C), and the solution was stirred by a magnetic stirrer for 6 hours. The solution after the stirring was transparent, and any precipitate was not observed in the solution.

The subsequent treatment of the glass substrate with ITO film and production of an organic EL element were carried out in the same manner as in Example 1.

The measurement results of the ITO film and the organic EL element are set forth in Table 3.

### Example 6

1.15 ml of hydrochloric acid (hydrogen chloride (HCl) concentration: 12 mol/l, available from Kanto Chemical Co., Ltd.), 125 ml of pure water (electric conductivity: 1 µS/cm) and 375 ml of ethanol were mixed and stirred to obtain a solution. To this solution, 0.005 mol of tetra-n-butoxysilane was added dropwise to prepare a surface treating solution 6 having a concentration of 0.03% by weight in terms of a Si atom and having pH of 2.0, followed by allowing the solution to stand for 1 hour. In this surface treating solution 6, a glass substrate with ITO film was immersed at roomtemperature (25°C), and the solution was stirred by a magnetic stirrer for 10 hours. The solution after the stirring was transparent, and any precipitate was not observed in the solution.

The subsequent treatment of the glass substrate with ITO film and production of an organic EL element were carried out in the same manner as in Example 1.

The measurement results of the ITO film and the organic EL element are set forth in Table 3.

### Example 7

125 ml of pure water (electric conductivity: 1 µS/cm) and 375 ml of ethanol were mixed and stirred to obtain a solution. To this solution, 0.005 mol of chlorotriethoxysilane was added dropwise to prepare a surface treating solution 7 having a concentration of 0. 03% by weight in terms of a Si atom and having pH of 1.7, followed by allowing the solution to stand for 1 hour. In this surface treating solution 7, a glass substrate with ITO film was immersed at room temperature (25°C), and the solution was stirred by a magnetic stirrer for 2 hours. The solution after the stirring was transparent, and any precipitate was not observed in the solution.

The subsequent treatment of the glass substrate with ITO film and production of an organic EL element were carried out in the same manner as in Example 1.

The measurement results of the ITO film and the organic EL element are set forth in Table 3.

### Example 8

A surface treating solution 4 was prepared in the same manner as in Example 4, and the solution was allowed to stand for 1 hour at room temperature. On a glass substrate with ITO film having been fixed onto a spin coating device, this solution was dropped so that the solution might cover the whole substrate, and the glass substrate with ITO film was immediately rotated at a spin rotational speed of 3000 rpm for 30 seconds to perform spin coating with the solution.

After the surface of the glass substrate with ITO film was allowed to stand for 1 hour at room temperature to dry the surface, work function of the ITO film surface and surface roughness of the ITO film were measured. The results are set forth in Table 3.

Subsequently, an organic EL element was produced in the same manner as in Example 1, except that the thus treated glass substrate with ITO film was used.

The measurement results of the ITO film and the organic EL element are set forth in Table 3.

### Example 9

A surface treating solution 4 was prepared in the same manner as in Example 4, and the solution was allowed to stand for 1 hour at room temperature. On a glass substrate with ITO film having been fixed onto a spin coating device, this solution was dropped, and the glass substrate with ITO film was immediately rotated at a spin rotational speed of 3000 rpm for 30 seconds to perform spin coating with the solution so that the solution might cover the whole substrate.

Subsequently, the surface of the glass substrate with ITO film was allowed to stand for 1 minute at room temperature. Thereafter, the glass substrate with ITO film was rotated at a spin rotational speed of 500 rpm with pouring pure water onto the glass substrate surface and then further rotated at a spin rotational speed of 3000 rpm for 30 seconds without pouring pure water.

Thereafter, the glass substrate with ITO film was allowed to stand for 1 hour at room temperature to dry the surface, and then, work function of the ITO film surface and surface roughness of the ITO film were measured. The results are set forth in Table 3.

Subsequently, an organic EL element was produced in the same manner as in Example 1, except that the thus treated glass substrate with ITO film was used.

The measurement results of the ITO film and the organic EL element are set forth in Table 3.

### Example 10

A surface treating solution 4 was prepared in the same manner as in Example 4, and the solution was allowed to stand for 1 hour at room temperature. In this solution, a glass substrate with ITO film having been fixed onto a dip coating device was dipped, and the substrate was immediately pulled up from the solution at a rate of 1 mm per second. The period of time from the initiation of dipping of the substrate to the completion of pull-up of the substrate was 3 minutes.

The glass substrate with ITO film pulled up from the aqueous solution was allowed to stand for 1 hour at room temperature to dry the surface, and then, work function of the ITO film surface and surface roughness of the ITO film were measured. The results are set forth in Table 3.

Subsequently, an organic EL element was produced in the same manner as in Example 1, except that the thus treated glass substrate with ITO film was used.

The measurement results of the ITO film and the organic EL element are set forth in Table 3.

### Example 11

A surface treating solution 4 was prepared in the same manner as in Example 4, and the solution was allowed to stand for 1 hour at roomtemperature. Inorderto deposit a filmofthe aqueous solution, the solution was spread out onto a glass substrate with ITO film by the use of a bar coater (No. 3 manufactured by Daiichi Rika Co., Ltd.) over a period of 2 seconds at a rate of 100 mm/sec.

Subsequently, the glass substrate with ITO film was allowed to stand for 1 hour at room temperature to dry the surface, and then, work function of the ITO film surface and surface roughness of the ITO film were measured. The results are set forth in Table 3.

Subsequently, an organic EL element was produced in the same manner as in Example 1, except that the thus treated glass substrate with ITO film was used.

The measurement results of the ITO film and the organic EL element are set forth in Table 3.

### Example 12

50 ml (50 g) of pure water (electric conductivity: 1 µS/cm) and 450 ml (400 g) of tetrahydrofuran were mixed and stirred to obtain a mixed solvent (proportion of water: 11% by mass). In this mixed solvent, 0.012 mol of sodiumhydrogencarbonate (NaHCO₃) was dissolved, and they were stirred to obtain a solution. To this solution, 0.005 mol of tetraphenoxysilane (available from Kanto Chemical Co., Ltd.) was added dropwise to prepare a surface treating solution 5 having a concentration of 0.03% by weight in terms of a Si atom and having pH of 9.5, followed by allowing the solution to stand for 1 hour. In this surface treating solution 5, a glass substrate with ITO film was immersed at room temperature (25°C), and the solution was stirred by a magnetic stirrer for 0.5 hour. The solution after the stirring was transparent, and any precipitate was not observed in the solution.

The subsequent treatment of the glass substrate with ITO film and production of an organic EL element were carried out in the same manner as in Example 1.

The measurement results of the ITO film and the organic EL element are set forth in Table 3.

### Comparative Example 1

A glass substrate with ITO film was transferred into a beaker filled with pure water, and the pure water was stirred by a magnet stirrer for 2 hours. This substrate was taken out, set immediately on a spin-drying device and rotated at 3000 rpm to dry the surface of the glass substrate with ITO film.

The glass substrate with ITO film was allowed to stand for 1 hour at room temperature to further dry the surface, and then, work function of the ITO film surface and surface roughness of the ITO film were measured in the same manner as in Example 1. The results are set forth in Table 3.

After the measurement, a luminescent layer, a cathode buffer layer and a cathode were formed on the ITO film side surface of the substrate in the same manner as in Example 1 to produce an organic EL element.

The measurement results of the resulting organic EL element are set forth in Table 3.

### Comparative Example 2

125 ml of pure water (electric conductivity: 1 µS/cm) and 375 ml of ethanol were mixed and stirred to prepare a solution C2 having pH of 7.0. Then, treatment of a glass substrate with ITO film and production of an organic EL element were carried out in the same manner as in Example 1, except that the solution C2 was used instead of the surface treating solution 1.

The measurement results of the ITO film and the organic EL element are set forth in Table 3.

### Comparative Example 3

125 ml of pure water (electric conductivity: 1 µS/cm) and 375 ml of ethanol were mixed and stirred to obtain a mixed solvent. In this mixed solvent, 0.012 mol of sodium hydrogencarbonate (NaHCO₃) was dissolved, and they were stirred to obtain a solution C3 having pH of 10.0. Then, treatment of a glass substrate with ITO film and production of an organic EL element were carried out in the same manner as in Example 3, except that the solution C3 was used instead of the surface treating solution 3.

The measurement results of the ITO film and the organic EL element are set forth in Table 3.

### Comparative Example 4

1.15 ml of hydrochloric acid (hydrogen chloride (HCl) concentration: 12 mol/l, available from Kanto Chemical Co., Ltd.), 125 ml of pure water (electric conductivity: 1 µS/cm) and 375 ml of ethanol were mixed and stirred to obtain a solution C4 having pH of 1.8. Then, treatment of a glass substrate with ITO film and production of an organic EL element were carried out in the same manner as in Example 4, except that the solution C4 was used instead of the surface treating solution 4.

The measurement results of the ITO film and the organic EL element are set forth in Table 3.

**Table 1**

| Element | Silane compound | Water (ml) | Organic solvent (type) | Organic solvent (ml) | pH |
|---|---|---|---|---|---|
| Ex. 1 | tetraethoxysilane | 125 | ethanol | 375 | 7.0 |
| Ex. 2 | tetraethoxysilane | 500 | - | - | 10.0 |
| Ex. 3 | tetraethoxysilane | 125 | ethanol | 375 | 10.0 |
| Ex. 4 | tetraethoxysilane | 125 | ethanol | 375 | 1.8 |
| Ex. 5 | tetraethoxysilane | 125 | isopropanol | 400 | 5.0 |
| Ex. 6 | tetra-n-butoxysilane | 125 | ethanol | 375 | 2.0 |
| Ex. 7 | chlorotriethoxysilane | 125 | ethanol | 375 | 1.7 |
| Ex. 8 | tetraethoxysilane | 125 | ethanol | 375 | 1.8 |
| Ex. 9 | tetraethoxysilane | 125 | ethanol | 375 | 1.8 |
| Ex. 10 | tetraethoxysilane | 125 | ethanol | 375 | 1.8 |
| Ex. 11 | tetraethoxysilane | 125 | ethanol | 375 | 1.8 |
| Ex. 12 | tetraphenoxysilane | 50 | tetrahydrofuran | 450 | 9.5 |
| Comp.Ex.1 | - | 500 | - | - | 7.0 |
| Comp.Ex.2 | - | 125 | ethanol | 375 | 7.0 |
| Comp.Ex.3 | - | 125 | ethanol | 375 | 10.0 |
| Comp.Ex.4 | - | 125 | ethanol | 375 | 1.8 |

**Table 2 Surface treatment procedure**

| Element | Surface treatment procedure |
|---|---|
| Ex. 1 | immersion (2 hrs) → pure water cleaning (5 min) → drying (spin) → allowing to stand (room temperature, 1 hr) |
| Ex. 2 | immersion (0.5 hr) → pure water cleaning (5 min) → drying (spin) → allowing to stand (room temperature, 1 hr) |
| Ex. 3 | immersion (0.5 hr) → pure water cleaning (5 min) → drying (spin) → allowing to stand (room temperature, 1 hr) |
| Ex. 4 | immersion (2 hrs) → pure water cleaning (5 min) → drying (spin) → allowing to stand (room temperature, 1 hr) |
| Ex. 5 | immersion (6 hrs) → pure water cleaning (5 min) → drying (spin) → allowing to stand (room temperature, 1 hr) |
| Ex. 6 | immersion (10 hrs) → pure water cleaning (5 min) → drying (spin) → allowing to stand (room temperature, 1 hr) |
| Ex. 7 | immersion (2 hrs) → pure water cleaning (5 min) → drying (spin) → allowing to stand (room temperature, 1 hr) |
| Ex. 8 | spin coating → allowing to stand (room temperature, 1 hr) |
| Ex. 9 | spin coasting → allowing to stand (room temperature, 1 min) → pure water cleaning (spin) → drying (spin) → allowing to stand (room temperature, 1 hr) |
| Ex. 10 | dip coating (3 mien) → allowing to stand (room temperature, 1 hr) |
| Ex. 11 | bar coating → allowing to stand (room temperature, 1 hr) |
| Ex. 12 | immersion (0.5 hr) → pure water cleaning (5 mien) → drying (spin) → allowing to stand (room temperature, 1 hr) |
| Comp.Ex.1 | immersion (2 hers) → drying (spin) → allowing to stand (room temperature, 1 hr) |
| Comp.Ex.2 | immersion (2 hrs) → pure water cleaning (5 min) → drying (spin) → allowing to stand (room temperature, 1 hr) |
| Comp.Ex.3 | immersion (0.5 hr) → pure water cleaning (5 min) → drying (spin) → allowing to stand (room temperature, 1 hr) |
| Comp.Ex.4 | immersion (2 hrs) → pure water cleaning (5 min) → drying (spin) → allowing to stand (room temperature, 1 hr) |

**Table 3 Evaluation of ITO film and organic EL element**

| Element | Work function (eV) | Surface roughness (nm) | Contact angle (°) | Luminous efficiency (cd/A) | Emission lifetime (hr) | Luminance unevenness (%) | Leakage current (mA/cm²) |
|---|---|---|---|---|---|---|---|
| Ex. 1 | -5.0 | 0.8 | not more than 5 | 6 | 10 | 16 | 0.080 |
| Ex. 2 | -5.1 | 0.6 | not more than 5 | 6 | 50 | 16 | 0.056 |
| Ex. 3 | -5.6 | 0.4 | not more than 5 | 18 | 190 | 15 | 0.022 |
| Ex. 4 | -5.9 | 0.4 | not more than 5 | 19 | 110 | 10 | 0.010 |
| Ex. 5 | -5.8 | 0.4 | not more than 5 | 17 | 90 | 12 | 0.019 |
| Ex. 6 | -5.6 | 0.5 | not more than 5 | 15 | 90 | 13 | 0.041 |
| Ex. 7 | -5.4 | 0.7 | not more than 5 | 8 | 50 | 15 | 0.051 |
| Ex. 8 | -5.8 | 0.4 | not more than 5 | 20 | 120 | 11 | 0.012 |
| Ex. 9 | -5.9 | 0.4 | not more than 5 | 20 | 130 | 8 | 0.010 |
| Ex. 10 | -5.8 | 0.4 | not more than 5 | 18 | 90 | 12 | 0.015 |
| Ex. 11 | -5.5 | 0.9 | not more than 5 | 18 | 70 | 18 | 0.071 |
| Ex. 12 | -5.6 | 0.5 | not more than 5 | 14 | 70 | 18 | 0.090 |
| Comp.Ex.1 | -4.8 | 1.0 | 35 | 2 | 0.2 | 25 | 0.120 |
| Comp.Ex.2 | -4.8 | 1.0 | 35 | 1 | 0.2 | 25 | 0.120 |
| Comp.Ex.3 | -4.9 | 2.0 | 35 | 1 | 0.1 | 35 | 0.220 |
| Comp.Ex.4 | -4.9 | 1.2 | 35 | 1.5 | 0.15 | 28 | 0.190 |

As shown in Table 3, by virtue of the surface treatment of the ITO film (anode), the work function of the ITO film (anode) was increased and the surface roughness thereof was decreased. Moreover, the luminous efficiency of the organic EL element was enhanced, and the emission lifetime was prolonged.

### Reference Signs List

- 1:: transparent substrate
- 2:: anode
- 3:: hole transport layer
- 4:: luminescent layer
- 5:: electron transport layer
- 6:: cathode

## Claims

1. A surface treatment method for electrodes, comprising a contact step of bringing an electrode made from a metal oxide into contact with a solution comprising a silane compound represented by the following formula (1) and/or a partially hydrolyzed condensate thereof and water,
Si (OR)ₚ(X)_{q(}OH)_{4-p-q} (1)
wherein each OR is independently an alkoxy group or an aryloxy group,
each X is independently a hydrolyzable group other than the above OR,
p is an integer of 1 to 4, q is an integer of 0 to 3, and p+q≤4.

2. The surface treatment method for electrodes as claimed in claim 1, wherein the silane compound is a tetraalkoxysilane.

3. The surface treatment method for electrodes as claimed in claim 2, wherein the tetraalkoxysilane is at least one compound selected from the group consisting of tetramethoxysilane, tetraethoxysilane, tetrapropoxysilane and tetrabutoxysilane.

4. The surface treatment method for electrodes as claimed in any one of claims 1 to 3, wherein the solution contains the silane compound and/or the partially hydrolyzed condensate thereof in an amount of 0.001 to 10% by mass in terms of a Si atom.

5. The surface treatment method for electrodes as claimed in any one of claims 1 to 4, wherein the solution comprises 10 to 80% by mass of water and 90 to 20% by mass of an alcohol of 1 to 3 carbon atoms, with the proviso that the total amount of them is 100% by mass.

6. The surface treatment method for electrodes as claimed in any one of claims 1 to 5, wherein pH of the solution is in the range of 1.0 to 5.0.

7. The surface treatment method for electrodes as claimed in any one of claims 1 to 5, wherein pH of the solution is in the range of 9.0 to 12.

8. The surface treatment method for electrodes as claimed in any one of claims 1 to 7, wherein the contact step is carried out by application of the solution on a surface of the electrode.

9. The surface treatment method for electrodes as claimed in claim 8, wherein the method of the application is a method comprising forming a liquid pool of the solution on the electrode surface and rotating the electrode in the in-plane direction of the surface to spread out the liquid pool so as to cover the whole of the electrode surface.

10. The surface treatment method for electrodes as claimed in any one of claims 1 to 7, wherein the contact step is carried out by immersing the electrode in the solution or spraying the solution to the electrode.

11. The surface treatment method for electrodes as claimed in claim 10, which further comprises a cleaning step of cleaning the electrode with water immediately after the contact step.

12. The surface treatment method for electrodes as claimed in any one of claims 1 to 11, which further comprises a heating step of heating the electrode to 60 to 250°C in any stage after the contact step (or in any stage after the cleaning step if the cleaning step is included).

13. The surface treatment method for electrodes as claimed in any one of claims 1 to 12, which further comprises an UV irradiation step of irradiating the electrode with ultraviolet rays in any stage after the contact step (or in any stage after the cleaning step if the cleaning step is included).

14. An electrode made from a metal oxide, which has been surface-treated by the method as claimed in any one of claims 1 to 13.

15. An electrode made from indium tin oxide, which has been surface-treated by the method as claimed in any one of claims 1 to 13 and has a work function, as measured by ultraviolet photoelectron spectroscopic analysis in the atmosphere, of -4.9 to -6.0 eV.

16. An organic electroluminescent element having a luminescent layer and a cathode laminated in this order on a surface-treated surface of an anode made from a metal oxide, said anode having been surface-treated by the method as claimed in any one of claims 1 to 13.
